# EUROPEAN PATENT SPECIFICATION

(11) **EP 3 664 274 B1**
(45) Date of publication and mention of the grant of the patent: **11.10.2023**
(21) Application number: 18841068.2
(22) Date of filing: 28.03.2018
(51) Int. Cl.: H02M 7/00, H01L 23/473, H01L 25/11, H05K 7/20

(54) **POWER CONVERSION DEVICE AND VEHICLE EQUIPPED WITH POWER CONVERSION DEVICE**
STROMUMWANDLUNGSVORRICHTUNG UND MIT STROMUMWANDLUNGSVORRICHTUNG AUSGESTATTETES FAHRZEUG
DISPOSITIF DE CONVERSION DE COURANT ET VÉHICULE ÉQUIPÉ DU DISPOSITIF DE CONVERSION DE COURANT

(30) Priority: 03.08.2017 JP 2017150656
(43) Date of publication of application: 10.06.2020
(73) Proprietor: Hitachi, Ltd., Tokyo 100-8280 (JP); Hitachi Building Systems Co., Ltd., Tokyo 101-8941 (JP)
(72) Inventor: HORIUCHI, Keisuke, Tokyo 100-8280 (JP); URUSHIWARA, Noriyoshi, Tokyo 100-8280 (JP); MAE, Kentarou, Tokyo 100-8280 (JP); ONUMA, Emi, Chiyoda-ku, Tokyo 101-8941 (JP); NAKATA, Kiyoshi, Tokyo 100-8280 (JP); KATAGIRI, Masaru, Tokyo 100-8280 (JP)
(74) Representative: Mewburn Ellis LLP
(86) International application number: PCT/JP2018/012752
(87) International publication number: WO 2019/026339

(56) References cited:
- EP-A1- 2 675 053
- EP-A1- 2 928 057
- EP-A2- 2 482 438
- WO-A1-2012/108048
- WO-A1-2013/005385
- WO-A1-2016/063386
- CN-A- 106 026 693
- JP-A- H11 220 869
- JP-A- 2011 151 995
- JP-A- 2013 179 104
- JP-A- 2015 198 545
- JP-A- 2016 066 974
- JP-A- 2016 213 945
- JP-A- 2016 213 946
- US-A- 6 021 060
- US-A1- 2016 143 193
- US-B1- 6 357 517

## Description

### Technical Field

The present invention relates to a power conversion device for vehicles.

### Background Art

The power conversion device is a device that controls a motor driving vehicles, such as electric railway vehicles, and is disposed under the vehicle floor, for example. Under the vehicle floor, many components, including an air-conditioning power supply, for example, have to be mounted in addition to this, and hence the power conversion device is requested to reduce in its size. In small sized packaging in high density, a high magnetic field is generated due to a large electric current, and the distance between a heat generating component that is a self-heating component, such as a bus bar, and electronic components, which are vulnerable to electromagnetic noise or heat, mounted on a control circuit or a drive circuit of light current systems becomes short, leading to problems of malfunctions of electronic components or a shortened lifetime due to thermal fatigue.

In Patent Literature 1, a base placed below the lower side of the semiconductor device isolates a filter capacitor from a gate circuit, and this reduces the influence of the temperature rises between components in an electric power converter and specifically prevents a temperature rise in a gate circuit, solving problems, such as malfunction or a shortened lifetime of the gate circuit.

In Patent Literature 2, the long-side direction of a power module in a nearly rectangle is placed in the direction orthogonal to tempering air passing between the cooling fins of a cooler, and this combines heat dissipation with a reduction in size. The main circuit current wire of the bus bar is placed in the direction orthogonal to tempering air, and a gate signal wire is placed in parallel with tempering air, and this provides a configuration in which noise is not easily included in gate signals without interference with each other.

In Patent Literature 3, a power conversion apparatus having bus bar terminals extending in the short-side direction and long-side direction of a power module is provided.

In Patent Literature 4, the DC-link capacitor of a traction inverter is sandwiched between laminated bus bars on the top side, where the capacitor is electrically connected to the bus bars, and a driver circuit board on the bottom side. The 2in1 or half-bridge power modules of the rectifier, inverter and brake chopper face the capacitor and are mounted in parallel rows on the vertical surface of a heat-sink.

### Citation List

### Patent Literature

Patent Literature 1: Japanese Patent No. 3834764
Patent Literature 2: Japanese Unexamined Patent Application Publication No. 2016-213945
Patent Literature 3: European Patent Application Publication No. 2675053A1
Patent Literature 4: CN106026693

### Summary of Invention

### Technical Problem

In the power conversion device described in Patent Literature 1, the capacitor is placed above a gate circuit board. Thus, in the case in which the shape of the capacitor disposed above is large, to heat dissipation due to self-heating of electronic device components on the gate circuit board, warm air fails to move above, and heat is rather confined, leading to a problem that the temperature of components on the gate circuit board is increased. Bus bars, such as conductors P, N, and U, are also main heat generating components. These bus bars have to be away from the gate circuit, and desirably placed above the capacitor as described in Patent Literature 1. However, in the case in which electric railway vehicles including subways for lines with a small tunnel diameter, for example, low-floor power conversion devices are requested. In some cases, there is not a space in the height direction enough to place bus bars above the capacitor. Supposing that in the case of a design in which the bus bar is placed on the side surface of the capacitor or below the capacitor, not above the capacitor, the distance between the gate circuit board placed below the capacitor and the bus bar fails to be reserved sufficiently, and the temperature rises of the components mounted on the gate circuit board are feared as a result of heat from the bus bar.

The power conversion device described in Patent Literature 2 has a configuration in which the main circuit current wire of the bus bar is provided orthogonal to tempering air, and a connecting point to the bus bar is desirably provided above the capacitor as described in Patent Literature 2. However, in the case in which a low-floor power conversion device is requested as described above, in some cases, there is not a space in the height direction enough to place bus bars above the capacitor. The configuration is provided in which the direction of tempering air passing between the cooling fins of a cooler where the size is desired to reduce (the size in the traveling direction) is the same as the width direction of the main circuit current passage of the bus bar, and this makes the main circuit current passage of the bus bar long and narrow, leading to a problem that the bus bar or the main circuit inductance in the inside of the capacitor is increased. As a result, an overshoot voltage is increased, and hence damage to elements is feared.

### Solution to Problem

A power conversion device according to the present invention is provided as set forth in claim 1.

### Advantageous Effects of Invention

According to the present invention, the effects below can be exerted.
A. The distance between the bus bar and the drive circuit board is separated, and hence the drive circuit board does not suffer as a result of heat of the bus bar. No obstacle is provided right above drive circuit board, and hence no heat is confined due to self-heating of the drive circuit board. In general, small-sized packaging in high density can be implemented.
B. The distance between the bus bar and the drive circuit board is separated, this can minimize the induction of an electric current to light current system wires, such as signal wires, due to the influence of a magnetic field generated by a heavy current system, and hence the present invention is effective to a reduction in noise.
C. Since a configuration is provided in which the width direction of the main circuit current passage of the bus bar is the same as the long-side direction of the power module, the width of the main circuit current passage of the bus bar can be sufficiently reserved, and the main circuit inductance can be made small. Thus, problems, such as malfunctions due to heat or noise and a shortened lifetime, can be solved, while an overshoot voltage is suppressed.

### Brief Description of Drawings

Fig. 1 is a perspective view when a power unit according to a first embodiment is disassembled.
Fig. 2 is a perspective view of a power conversion device according to the first embodiment.
Fig. 3 is a diagram showing the circuit block configuration of the power conversion device according to the first embodiment and an electric railway vehicle mounted with the power conversion device.
Fig. 4 is an outside perspective view of a 2in power module according to the first embodiment.
Fig. 5 is a diagram showing the arrangement of an anti-noise core and an electric current sensor according to the first embodiment.
Fig. 6 is a diagram showing a power module configuration in single parallel arrangement according to a second embodiment.
Fig. 7 is a diagram showing the structure of a power unit according to a third embodiment.

### Description of Embodiments

In the following, first to third embodiments, as embodiments that embody the present invention, will be described in detail with reference to the drawings.

### First Embodiment

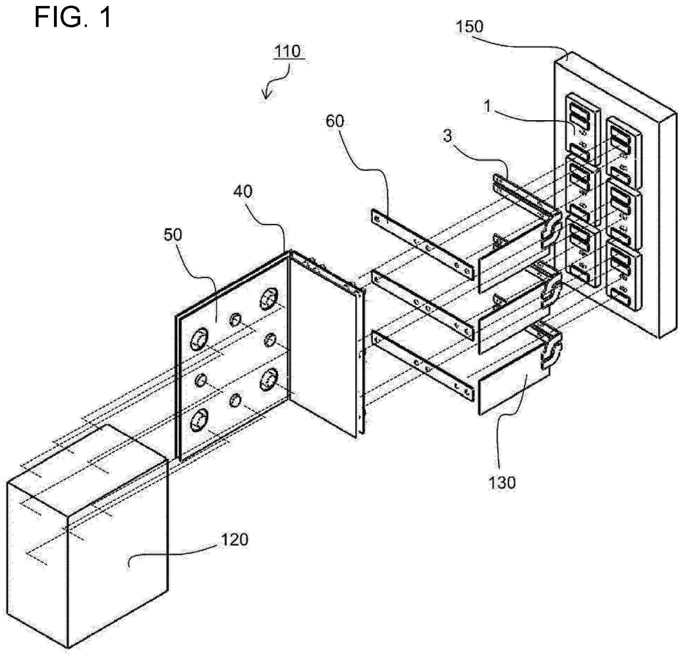

Fig. 1 is a perspective view when a power unit 110 according to a first embodiment of the present invention is disassembled.

The power unit 110 is composed of a cooler 150, a plurality of 2in1 power modules 1, a capacitor 120, a positive bus bar 40, a negative bus bar 50, a control signal wire 3, a drive circuit board 130, and an alternating bus bar 60.

The plurality of 2in1 power modules 1 is mounted on the cooler 150. Three 2in1 power modules 1 are arranged in the vertical direction on the cooler 150, the electric power terminals (the positive bus bar 40, the negative bus bar 50, and the alternating bus bar 60) from the 2in1 power modules 1 are placed on one side, and the control signal wires 3 are placed on the other side. The capacitor 120 is placed on the opposite side of the cooler 150 with the 2in1 power module 1 sandwiched, and the drive circuit board 130 having a gate drive circuit is placed on the control signal wires 3.

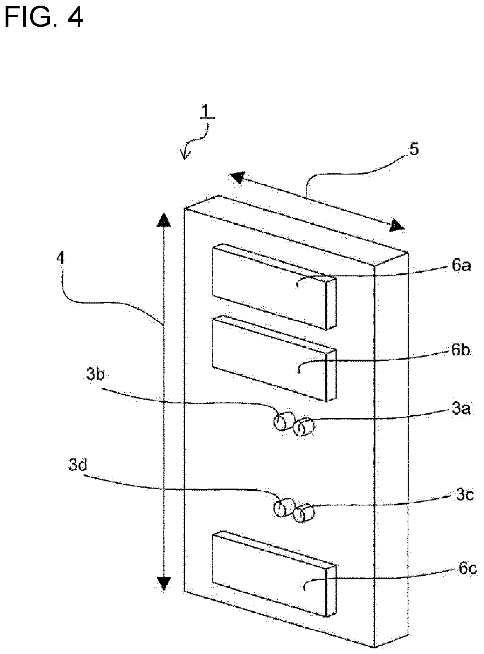

Here, as shown in Fig. 4, described later, the 2in1 power module 1 is in a nearly rectangular cuboid shape, and is characterized in that a module positive electrode terminal 6a, a module negative electrode terminal 6b, and a module alternating terminal 6c are provided on the short side along a long-side direction 4 of the module, and the control signal wires 3 are drawn from the space between the module negative electrode terminal 6b and the module alternating terminal 6c. In the 2in1 power module 1, a short-side direction 5 of the module is the traveling direction of an electric railway vehicle 900, the long-side direction 4 of the module is the vertical direction, and hence the length of the power unit 110 in the traveling direction can be shortened, yielding the effect of reducing the pressure loss of the cooler 150 that cools the 2in1 power modules 1 using running winds.

The electric power terminals (the positive bus bar 40, the negative bus bar 50, and the alternating bus bar 60) from the 2in1 power modules 1 are placed on one side, and the control signal wires 3 are placed on the other side. Thus, the bus bars of the heavy current system generating a magnetic field can be separated from the control signal wires 3 of the light current system, and malfunctions, such as generating an induced current on the control signal wire 3 due to electromagnetic noise can be suppressed.

A large electric current flows in the bus bars in a form of Joule heat to cause self-heating, and the ambient air is warmed sue to natural convection. Therefore, electronic components (e.g. an electrolysis capacitor, a transformer, an optical folder, and any other component), which are vulnerable to heat, mounted on the control signal wires 3 or the drive circuit board 130 are placed at positions apart from the bus bars as much as possible, and hence problems, such as generation of malfunctions and a shortened lifetime, are to be solved. The positive bus bar 40 and the negative bus bar 50 are adjacent to each other, and take a configuration in which when electric currents in the reverse direction flows, magnetic fields generated from each other are canceled to reduce mutual inductance.

The 2in1 power module 1 similarly takes a low inductance configuration in which the module positive electrode terminal 6a and the module negative electrode terminal 6b are adjacent to each other in the inside. Therefore, the inductance of the main circuit loop from the capacitor 120 to the positive bus bar 40, from the positive bus bar 40 to the module positive electrode terminal 6a, from the module positive electrode terminal 6a to the module negative electrode terminal 6b, from the module negative electrode terminal 6b to the negative bus bar 50, and from the negative bus bar 50 to the capacitor 120 can be reduced, also yielding the effect of suppressing an overshoot voltage.

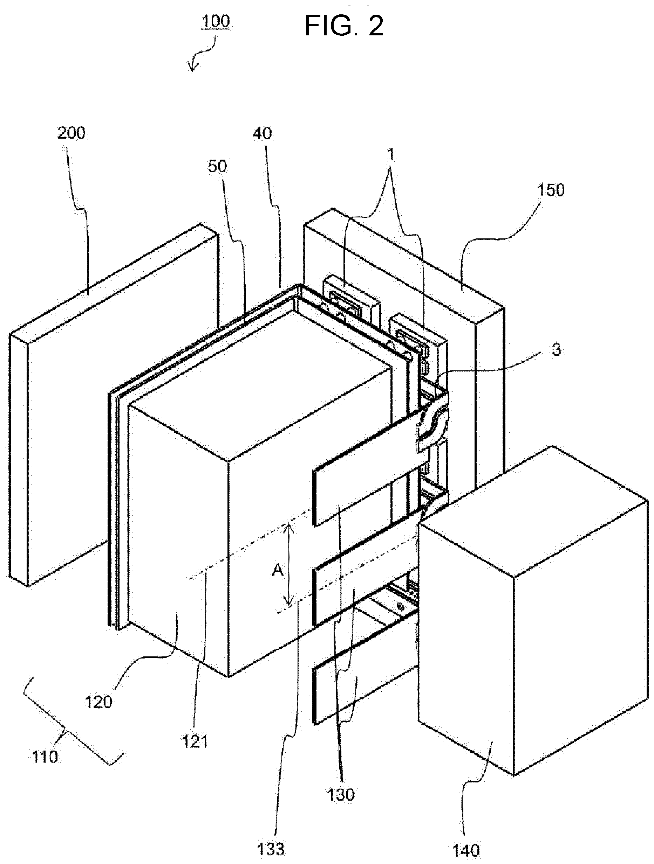

Fig. 2 is a perspective view of a power conversion device 100 according to the first embodiment of the present invention.

The power conversion device 100 composed of the power unit 110 shown in Fig. 1, a control circuit board 140, and a breaker 200. The control circuit board 140 outputs a switching command to the drive circuit board 130 of the power unit 110, receives a control signal, such as a voltage, electric current, and temperature, from the drive circuit board 130. The control circuit determines the status from this control signal, and determines whether to continue switching. The breaker 200 blocks electric power in an emergency (in an abnormality), hence exerting the function of preventing the destruction of the power unit 110 and in turn the destruction of an electric power substation.

Here, the breaker 200 that is a heavy current system is placed on the side of the positive bus bar 40, the negative bus bar 50, and the alternating bus bar 60 in the power unit 110, and the control circuit board 140 that is a light current system is placed on the drive circuit board 130 side of the power unit 110. With this configuration, problems, such as the occurrence of malfunctions on the control circuit board 140 mounted with electronic components vulnerable to heat or electromagnetic noise, are to be solved.

The power unit 110 shown in Fig. 2 has a configuration in which the exploded diagram shown in Fig. 1 is assembled. A gravity direction center line 121 (an alternate long and short dash line) of the capacitor 120 is located on the upper side of a gravity direction center line 133 (an alternate long and short dash line) of the drive circuit board 130 in the center, and a distance A between both of the center lines is a finite value. With this configuration, the electronic components on the drive circuit board 130 can be prevented from contacting the air warmed by receiving heat from the units and collected above the housing of the power conversion device 100, and hence problems, such as the occurrence of a malfunction of the control circuit board 130 and are to be solved.

Note that in Fig. 2, the case is described in which the breaker 200 is a part of the power conversion device 100. However, it does not matter that the breaker 200 is detached and separately provided.

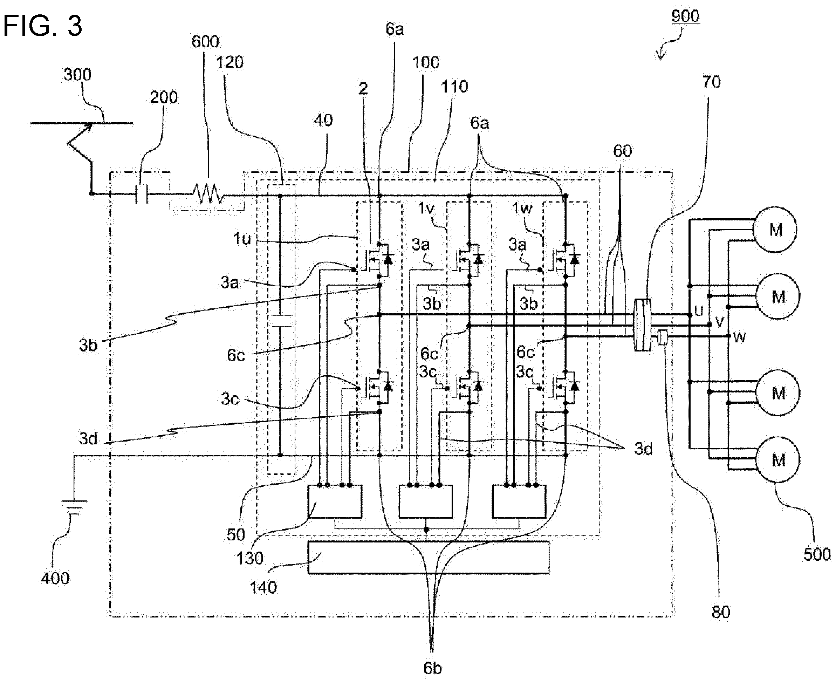

Fig. 3 is a diagram showing the circuit block configuration of the power conversion device 100 according to the first embodiment and the electric railway vehicle 900 mounted with the power conversion device 100. As shown in Fig. 3, the electric railway vehicle 900 that is a movable body includes the power conversion device 100 is composed of the breaker 200 and the inverter circuit and four motors 500. These induced motors 500 are connected to four wheels of the electric railway vehicle 900.

The power conversion device 100 is connected across a power line 300 and a ground part 400, such as rails and a car body, and supplies alternating-current power to the induced motors 500 for driving. Fig. 3 shows an example in which the power line 300 supplies direct-current power. However, this example is nonlimiting. The power line 300 may supply alternating-current power. In the case in which the power line 300 supplies alternating-current power, the electric railway vehicle 900 includes a converter module that converts the alternating current into direct current on the preceding stage of the capacitor 120, and this direct-current power is supplied to the power conversion device 100.

The power conversion device 100 is configured including the breaker 200 for emergency stop in an abnormality, the power unit 110 that generates an alternating current at a predetermined frequency from a direct current, and the control circuit board 140 that supplies control signals from the power unit 110 corresponding to a state.

The power unit 110 is configured including the capacitor 120 that stabilizes and smooths the supplied direct current, the 2in1 power modules 1 (1u, 1v, and 1w) mounted with semiconductor devices 2, and the drive circuit board 130 mounted with a driver circuit that drives and controls the 2in1 power modules 1 corresponding to a control command from the control circuit board 140.

The power unit 110 is a three-phase bridge circuit composed of the 2in1 power module 1u mounted with an upper-and-lower arm series circuit in the U-phase, the 2in1 power module 1v mounted with an upper-and-lower arm series circuit in the V-phase, and the 2in1 power module 1w mounted with an upper-and-lower arm series circuit in the W-phase. In the following, when the 2in1 power modules 1u, 1v, and 1w in the phases are not discriminated specifically, the 2in1 power modules 1u, 1v, and 1w are simply written in the power module 1.

The power modules 1u, 1v, and 1w are configured in which an upper-arm-side electric current switch circuit and a lower-arm-side electric current switch circuit are placed in series. The upper-arm-side electric current switch circuit is a circuit having an IGBT (Insulated Gate Bipolar Transistor) or MOSFET (metal-oxide-semiconductor field-effect transistor) connected in parallel with a diode that are the semiconductor devices 2, and the lower-arm-side electric current switch circuit is a circuit having an IGBT or MOSFET connected in parallel with a diode.

An interface on the positive bus bar 40 side of the power module 1 is the module positive electrode terminal 6a, and an interface on the negative bus bar 50 side is the module negative electrode terminal 6b. The module positive electrode terminal 6a is connected to the positive electrode of the capacitor 120 through the positive bus bar 40 in the power unit 110. Similarly, the module negative electrode terminal 6b is connected to the negative electrode of the capacitor 120 through the negative bus bar 50. As shown in Figs. 1 and 2, the positive bus bar 40 and the negative bus bar 50 are packaged adjacent to each other in order to implement a reduction in inductance for the purpose of suppressing an overshoot voltage.

The connecting portion of the upper-arm-side electric current switch circuit to the lower-arm-side electric current switch circuit of the power module 1 is the module alternating terminal 6c. From the module alternating terminal 6c of the power module 1u, an alternating current U in a U-phase is outputted. From the module alternating terminal 6c of the power module 1v, an alternating current V in a V-phase is outputted. From the module alternating terminal 6c of the power module 1w, an alternating current W in a W-phase is outputted. The alternating currents U, V, and W that are outputted three phases are supplied to the motors 500.

Upper arm gate signals outputted from the drive circuit board 130, on which the driver circuit is mounted, to the power modules 1 (1u, 1v, and 1w) are supplied to the semiconductor devices 2 on the upper arm in the phases through upper arm gate signal terminals 3a. Lower arm gate signals outputted from the drive circuit board 130 to the power modules 1 (1u, 1v, and 1w) are supplied to the semiconductor devices 2 on the lower arm in the phases through a lower arm gate signal terminal 3c. With the upper arm gate signals and the lower arm gate signals, the amplitude or the phase of the alternating currents U, V, and W, for example, are controlled.

Upper arm source signals are supplied from the source signal wires of the semiconductor devices 2 on the upper arm in the phases to the drive circuit board 130 through upper arm source signal terminals 3b. Similarly, lower arm source signals are supplied from the source signal wires of the semiconductor devices 2 on the lower arm in the phases to the drive circuit board 130 through lower arm source signal terminals 3d.

The upper arm gate signal terminal 3a and the upper arm source signal terminal 3b are control signal wires that switch-drive the semiconductor device 2 on the upper arm. Similarly, the lower arm gate signal terminal 3c and the lower arm source signal terminal 3d are control signal wires that switch-drive the semiconductor device 2 on the lower arm. In the following, these signal wires are sometimes written in the control signal wire 3 in a general term.

The control circuit board 140 includes a microcomputer configured to operate the switching timing of each of the semiconductor devices 2 on the upper arm and the lower arm, and outputs a switching operation command to each of the semiconductor devices 2 through the drive circuit board 130.

The drive circuit board 130 detects an overcurrent on the source electrode of each of the semiconductor devices 2. On the semiconductor device 2 in which an overcurrent is detected, the drive circuit board 130 stops the switching operation of the semiconductor device 2 and protects the semiconductor device 2 from the overcurrent. To the control circuit board 140, control signals 3 detected from a temperature sensor (not shown) provided on the power module 1 or a detection circuit (not shown) configured to detect a direct current voltage applied across the drain and the source of the semiconductor device 2, for example. The control circuit board 140 detects abnormalities, such as an over temperature, overcurrent, and overvoltage, based on the control signals 3. In the case in which the control circuit board 140 detects these abnormalities, the control circuit board 140 stops the switching operation of all the semiconductor devices 2, and protects the power module 1 from these abnormalities.

The power unit 110 according to the first embodiment is a device in which the 2in1 power module for one phase configuring a series circuit with two sets of the semiconductor devices 2 on the vertical arm is mounted for three phases. However, the 2in1 power module may be replaced with a 6in1 power module in which vertical arms for three phases are formed in a single power module or a 1in1 power module configured of one arm alone. In the case in which an output electric current requested corresponding to the motor-side torque is greater than an allowable output electric current per power module 1, the number of the power modules 1 may be increased for parallel connection. In addition to the circuit configuration shown in Fig. 3, the power conversion device 100 may have a device configuration having a function of charging and discharging a battery.

The alternating bus bar 60 is connected to the motor 500 through a core 70 after an electric current sensor 80. Here, the core 70 formed of a material, ferrite, for example. The alternating bus bar 60 is penetrated into the hole of the core 70 to configure a coil with the bus bar and the ferrite core (an inductor having impedance that becomes higher as the frequency becomes higher), and hence radio frequency noise can be attenuated.

When an induced current due to the alternating bus bar 60 is carried through the core 70, a magnetic flux is generated to convert the energy of the electric current into magnetic energy. In the conversion of the magnetic energy again into electric current energy due to an electric current change, a part of the electric current energy is lost as a magnetic loss, yielding the effect of noise removal. For example, the earth line of the motor 500 is also connected to the power module 110 through the core (not shown) and an earth resistor, and hence radiation noise can also be suppressed.

The electric current sensor 80 is in a ring shape like the magnetic core, for example. The alternating bus bar 60 is penetrated into the electric current sensor 80 to generate an induced current corresponding to the wire turns of a winding wire on the secondary side such that a magnetic flux generated in the magnetic core is canceled. A shunt resistor is provided on an electric current passage on the secondary side to detect voltages at both ends of this shunt resistor, and hence an electric current carried through the alternating bus bar 60 can be found by conversion.

As described above, the electric current sensor 80 is provided on the alternating bus bar 60 on the output side of the power module 110, the obtained current value signals are sent to the control circuit board 140. The control circuit determines an appropriate output current value corresponding to the torque load of the motor 500 or a bus bar allowable the temperature, and imparts gate signals (3a and 3c) to the semiconductor devices 2 through the drive circuit board 130. Thus, feedback control is made possible.

Fig. 4 is an outside perspective view of the 2in power module 1 according to the first embodiment.

As shown in Fig. 3, the 2in1 power module 1 corresponds to one phase, 1u, 1v, and 1w, of the upper-and-lower arm series circuit. In the inside of the 2in1 power module 1, the semiconductor devices 2 (not shown) that are an IGBT or MOSFET and a diode, are mounted. The shape of the power module 1 is in a nearly rectangular cuboid, and the module positive electrode terminal 6a, the module negative electrode terminal 6b, and the module alternating terminal 6c are provided on the short side along the long-side direction 4 of the module.

Since the module positive electrode terminal 6a and the module negative electrode terminal 6b are module power terminals 6 through which a large electric current is carried, the module positive electrode terminal 6a and the module negative electrode terminal 6b are placed adjacent to each other, and the terminals having the opposite orientations of electric currents are brought close to each other, yielding the effect of reducing mutual inductance. On the other hand, the module alternating terminal 6c is placed at the position apart from a pair of the module positive electrode terminal 6a and the module negative electrode terminal 6b.

In the space between the module negative electrode terminal 6b and the module alternating terminal 6c, the upper arm gate signal terminal 3a, the upper arm source signal terminal 3b, the lower arm gate signal terminal 3c, and the lower arm source signal terminal 3d, which are the control signal wires 3 of the light current system, and a temperature detection signal terminal and a drain signal terminal, not shown, are provided.

As described above, all the control signal wires 3 are collectively placed in the space, which is the center part of the power module 1, between the pair of the module positive electrode terminal 6a and the module negative electrode terminal 6b and the module alternating terminal 6c, and hence the influence of a magnetic field generated at the pair of the module positive electrode terminal 6a and the module negative electrode terminal 6b can be minimized, and signal noise can be reduced.

The control signal wires 3 are electrically connected at a place apart from the power module 1 using a conductor bus bar or twisted wire in a bundle of a plurality of signal wires.

As described above, in the plurality of 2in1 modules, the positive electrode terminal, the negative electrode terminal, and the alternating terminal are placed along the long-side direction side of the 2in1 module in the written order. However, these terminals may be placed in the inverted order of the alternating terminal, the negative electrode terminal, and the positive electrode terminal.

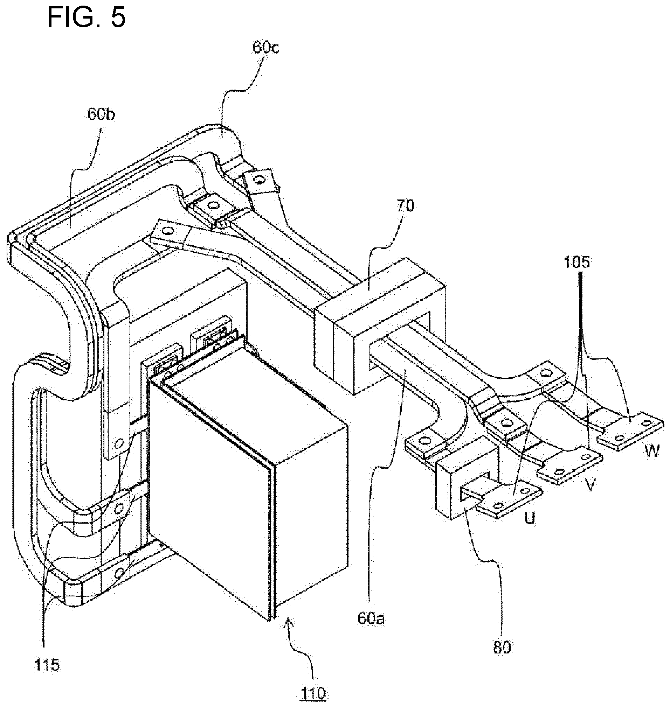

Fig. 5 is a diagram showing the arrangement of the anti-noise core 70 and the electric current sensor 80 according to the first embodiment. In Fig. 5, the case is shown in which the number of the core 70 is two, and the number of the electric current sensor 80 is one. However, the numbers and arrangement are not limited to these.

The alternating bus bar 60 is configured of a U-phase alternating bus bar 60a, a V-phase alternating bus bar 60b, and a W-phase alternating bus bar 60c. However, these are connected from power unit alternating output terminals 115 provided on the side surface of the power unit 110 to power conversion device alternating output terminals 105 through the core 70 provided above the power unit 110 and through the electric current sensor 80 (in Fig. 5, only the U-phase).

The core 70 has a structure in which the alternating bus bar 60 in three phases is penetrated into the hole of the core 70 as described above, and the electric current sensor 80 also has a structure in which the electric current sensor 80 is in a ring shape and the alternating bus bar 60 is penetrated like the magnetic core, for example, as described above.

### Second Embodiment

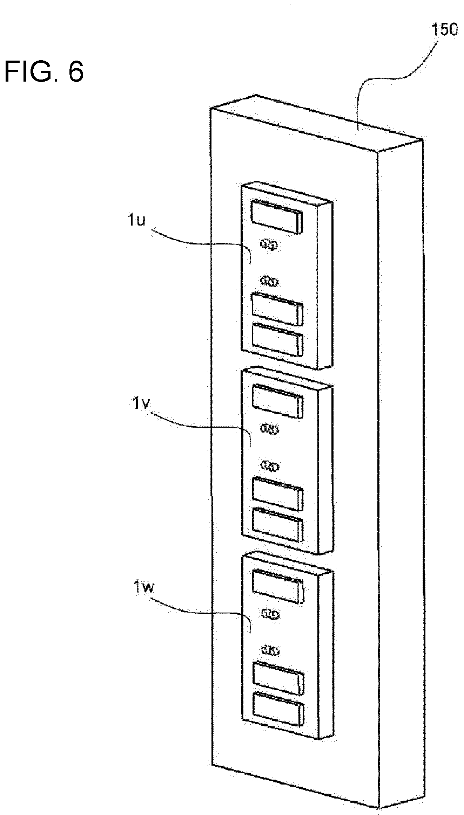

Fig. 6 is a diagram showing a power module configuration in single parallel arrangement according to a second embodiment of the present invention.

In Figs. 1 to 5 in the previous drawings, since a 1C4M configuration is provided in which four motors 500 (M: Motor) are under control (C: Control) by one control circuit board 140, in order to output electric currents for four motors necessary to a power conversion device 100, two 2in1 power modules 1 are arranged in parallel to increase output electric currents.

On the other hand, in the case of the 1C2M configuration, i.e., in the case in which two motors 500 are mounted and driven on the bogie of an electric railway vehicle 900, the motor electric current can be a half of the 1C4M configuration. Thus, the number of 2in1 power modules 1 in parallel arrangement can be single parallel arrangement that the number is a half. Fig. 6 shows this case, and a further reduction in size of the power conversion device can be implemented. In Fig. 6, as described above, regarding the positive electrode of terminal, the negative electrode terminal, and the alternating terminal the arrangement of (the order of arrangement) of the 2in1 power module 1, the arrangement is shown in which the W-phase (1w) is placed in the inverted order to the U-phase (1u) and the V-phase (1v).

### Third Embodiment

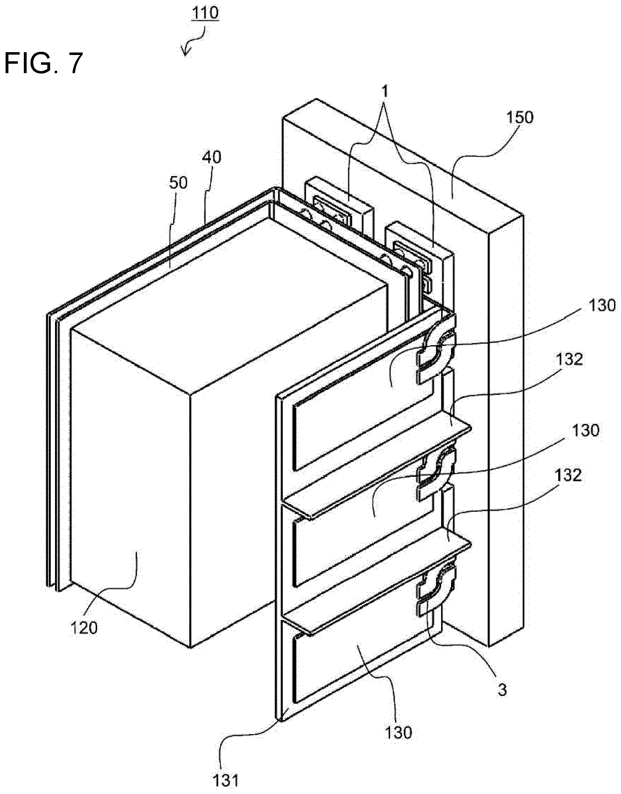

Fig. 7 is a diagram showing the structure of a power unit 110 according to a third embodiment of the present invention. The third embodiment is characterized in that drive circuit board partition plates 132 are provided.

The drive circuit board 130 shown in Figs. 1 and 2 in the previous drawings has a configuration in which three substrates of the 2in1 circuits connected in the individual phases suited to the 2in1 power module 1 in three phases are provided. Since a plurality of substrates is provided, air warmed by heat generating components on the substrate located below becomes light and rises depending on the layout of components on the substrates, and this might cause the influence as a result of heat to components vulnerable to heat on the substrate located above.

Therefore, in the embodiment, the drive circuit board partition plate 132 is provided on a drive circuit board fixing plate 131 between the substrates in the vertical direction, and hence the effect is exerted in which heat is blocked such that the substrate located below does not warm the substrate located above.

### List of Reference Signs

1: 2in1 power module
1u: U-phase 2in1 power module
1v: V-phase 2in1 power module
1w: W-phase 2in1 power module
2: semiconductor device
3: control signal wire
3a: upper arm gate signal terminal
3b: upper arm source signal terminal
3c: lower arm gate signal terminal
3d: lower arm source signal terminal
4: module long-side direction
5: module short-side direction
6: module power terminal
6a: module positive electrode terminal
6b: module negative electrode terminal
6c: module alternating terminal
40: positive bus bar
50: negative bus bar
60: alternating bus bar
60a: U-phase alternating bus bar
60b: V-phase alternating bus bar
60c: W-phase alternating bus bar
70: core
80: electric current sensor
100: power conversion device
105: power conversion device alternating output terminal
110: power unit
115: power unit alternating output terminal
120: capacitor
121: capacitor gravity direction center line
130: drive circuit board
131: drive circuit board fixing plate
132: drive circuit board partition plate
133: drive circuit board gravity direction center line
140: control circuit board
150: cooler
200: breaker
300: power line
400: ground part
500: motor
600: reactor
900: electric railway vehicle

## Claims

1. A power conversion device comprising:
plural 2in1 power modules (1) each having a rectangular cuboid shape defining a long-side direction (4) that is a vertical direction and a short-side direction (5) that is a horizontal direction;
a cooler (150) configured to cool the 2in1 power modules (1) ;
a capacitor (120) facing a first rectangular side of each 2in1 power module (1), and having a vertical front surface facing the cooler and 2in1 power modules, a vertical rear surface, a left-hand side vertical surface comprising terminals for connection to DC bus-bars, and a right-hand side vertical surface parallel to the left-hand side vertical surface;
an L-shaped positive DC bus bar (40) connected to the 2in1 power modules (1), the positive DC bus bar (40) having an electric power terminal for connection to the capacitor (120);
an L-shaped negative DC bus bar (50) connected to the 2in1 power modules (1), the negative DC bus bar (50) having an electric power terminal for connection to the capacitor (120);
respective control signal wires (3) connected to the 2in1 power modules (1); and
respective drive circuit boards (130), located on a same plane, and configured to deliver control signals to the control signal wires (3);
wherein the 2in1 power modules (1) are mounted to the cooler (150) along a vertical direction that is also a long-side direction (4) of the 2in1 power modules (1);
the power conversion device further comprises: plural AC bus bars (60) respectively connected to the 2in1 power modules (1), each AC bus bar (60) having an output terminal (115), each AC bus bar extending horizontally parallel to each other on the same plane parallel to the surface of the cooler;
the L-shaped positive DC bus bar and L-shaped negative DC bus bar respectively having vertical front portions parallel to the cooler for electrical connection to the power modules and located between the vertical front surface of the capacitor and the AC bus bars and side vertical portions perpendicular to the cooler, the side vertical portions extending parallel to the left-hand side vertical surface of the capacitor, and the side vertical portions respectively containing the electric power terminals for connection to the capacitor; and
wherein connections of the control signal wires (3) to the respective drive circuit boards (130) together with the drive circuit boards (130) face the right-hand side vertical surface of the capacitor (120);
and wherein a center line (121), perpendicular to the vertical direction and the cooler (150), of the capacitor (120) is located on an upper side of a center line (133), perpendicular to the vertical direction and the cooler, of the drive circuit boards (130).

2. The power conversion device according to claim 1,
wherein in each 2in1 power module (1), a positive DC electrode terminal (6a), a negative DC electrode terminal (6b), and an AC terminal (6c) are disposed in that order or the opposite order along the vertical direction, and a connection terminal of the respective control signal wire (3) is disposed in a space between the negative DC electrode terminal (6b) and the AC terminal (6c);
the positive DC electrode terminal (6a) is connected to the capacitor (120) with a conductor plate forming the positive DC bus bar (40);
the negative DC electrode terminal (6b) is connected to the capacitor (120) with a conductor plate forming the negative DC bus bar (50); and
the positive DC bus bar (40) and the negative DC bus bar (50) are adjacent to each other in a parallel plate shape.

3. The power conversion device according to claim 2,
wherein each AC bus bar (60) extends from one of the AC terminals (6c) in the short-side direction of the 2in1 power modules (1), penetrates a core (70) and an electric current sensor (80) provided above the plurality of the 2in1 power modules (1), each AC bus bar (60) being drawn from above the power conversion device (100).

4. The power conversion device according to any one of claims 1 to 3,
wherein a control circuit board (140) is disposed on the same side of the 2in1 power modules (1) as the drive circuit boards (130).

5. The power conversion device according to any one of claims 1 to 4,
wherein a breaker (200) is disposed on the same side of the 2in1 power modules (1) as the electric power terminals of the positive DC bus bar (40) and the negative DC bus bar (50), and the output terminals (115) of the AC bus bars (60).

6. The power conversion device according to any one of claims 1 to 5,
wherein the drive circuit boards (130) are arranged in the vertical direction, and partition plates (132) are provided between the drive circuit boards (130).

7. The power conversion device according to any one of claims 1 to 6,
wherein the power conversion device (100) is an inverter circuit in which the 2in1 power modules (1) are each applied to individual phases of three-phase AC power.

8. The power conversion device according to any one of claims 1 to 7,
wherein in the power conversion device (100) is configured to be mounted on a vehicle (900), the short-side direction of the 2in1 power modules (1) is a traveling direction of the vehicle (900) .

9. A vehicle mounted with the power conversion device (100) according to claim 8.

## Patentansprüche

1. Leistungswandlervorrichtung, umfassend:
mehrere 2-in-1-Leistungsmodule (1), von denen jedes eine rechteckige Quaderform aufweist, die eine Längsseitenrichtung (4), die eine vertikale Richtung ist, und eine Breitenseitenrichtung (5) definiert, die eine horizontale Richtung ist;
einen Kühler (150), der ausgelegt ist, um die 2-in-1-Leistungsmodule (1) zu kühlen;
einen Kondensator (120), der einer ersten rechteckigen Seite jedes 2-in-1-Leistungsmoduls (1) zugewandt ist und eine vertikale Vorderseitenfläche, die dem Kühler und 2-in-1-Leistungsmodulen zugewandt ist, eine vertikale Rückseitenfläche, eine linke vertikale Seitenfläche, umfassend Anschlüsse zur Verbindung mit Gleichstrom-Sammelschienen, und eine rechte vertikale Seitenfläche parallel zur linken vertikalen Seitenfläche aufweist;
eine L-förmige positive Gleichstrom-Sammelschiene (40), die mit den 2-in-1-Leistungsmodulen (1) verbunden ist, wobei die positive Gleichstrom-Sammelschiene (40) einen elektrischen Leistungsanschluss zur Verbindung mit dem Kondensator (120) aufweist;
eine L-förmige negative Gleichstrom-Sammelschiene (50), die mit den 2-in-1-Leistungsmodulen (1) verbunden ist, wobei die negative Gleichstrom-Sammelschiene (50) einen elektrischen Leistungsanschluss zur Verbindung mit dem Kondensator (120) aufweist;
entsprechende Steuersignaldrähte (3), die mit den 2-in-1-Leistungsmodulen (1) verbunden sind; und
entsprechende Ansteuerleiterplatten (130), die sich auf derselben Ebene befinden und ausgelegt sind, um Steuersignale an die Steuersignaldrähte (3) zu leiten;
wobei die 2-in-1-Leistungsmodule (1) entlang einer vertikalen Richtung, die auch eine Längsseitenrichtung (4) der 2-in-1-Leistungsmodule (1) ist, an dem Kühler (150) angebracht sind;
wobei die Leistungswandlervorrichtung ferner Folgendes umfasst: mehrere Wechselstrom-Sammelschienen (60), die jeweils mit den 2-in-1-Leistungsmodulen (1) verbunden sind, wobei jede Wechselstrom-Sammelschiene (60) einen Ausgangsanschluss (115) aufweist, wobei sich jede Wechselstrom-Sammelschiene horizontal parallel zueinander auf derselben Ebene parallel zu der Oberfläche des Kühlers erstreckt;
wobei die L-förmige positive Gleichstrom-Sammelschiene und die L-förmige negative Gleichstrom-Sammelschiene jeweils vertikale Vorderseitenabschnitte, die parallel zum Kühler sind, zur elektrischen Verbindung mit den Leistungsmodulen und die sich zwischen der vertikalen Vorderseitenfläche des Kondensators und den Wechselstrom-Sammelschienen erstrecken, und vertikale Seitenabschnitte aufweisen, die normal zu dem Kühler angeordnet sind, wobei sich die vertikalen Seitenabschnitte parallel zu der linken vertikalen Seitenfläche des Kondensators erstrecken und wobei die vertikalen Seitenabschnitte jeweils die elektrischen Leistungsanschlüsse zur Verbindung mit dem Kondensator enthalten; und
wobei Verbindungen der Steuersignaldrähte (3) mit den entsprechenden Ansteuerleiterplatten (130) zusammen mit den Ansteuerleiterplatten (130) der rechten vertikalen Seitenfläche des Kondensators (120) zugewandt sind;
und wobei eine Mittellinie (121), normal zu der vertikalen Richtung und dem Kühler (150), des Kondensators (120) auf einer Oberseite einer Mittellinie (133), normal zu der vertikalen Richtung und dem Kühler, der Ansteuerleiterplatten (130) angeordnet ist.

2. Leistungswandlervorrichtung nach Anspruch 1,
wobei in jedem 2-in-1-Leistungsmodul (1), ein positiver Gleichstromelektrodenanschluss (6a), ein negativer Gleichstromelektrodenanschluss (6b) und ein Wechselstromanschluss (6c) in dieser Reihenfolge oder in umgekehrter Reihenfolge entlang der vertikalen Richtung angeordnet sind, und ein Verbindungsanschluss des entsprechenden Steuersignaldrahts (3) in einem Raum zwischen dem negativen Gleichstromelektrodenanschluss (6b) und dem Wechselstromanschluss (6c) angeordnet ist;
der positive Gleichstromelektrodenanschluss (6a) mit dem Kondensator (120) über eine Stromleitungsplatte verbunden ist, die die positive Gleichstrom-Sammelschiene (40) ausbildet;
der negative Gleichstromelektrodenanschluss (6b) mit dem Kondensator (120) über eine Stromleitungsplatte verbunden ist, die die negative Gleichstromsammelschiene (50) ausbildet; und
die positive Gleichstrom-Sammelschiene (40) und die negative Gleichstrom-Sammelschiene (50) benachbart zueinander in einer parallelen Plattenform angeordnet sind.

3. Leistungswandlervorrichtung nach Anspruch 2,
wobei sich jede Wechselstrom-Sammelschiene (60) von einem der Wechselstromanschlüsse (6c) in der Breitenseitenrichtung der 2-in-1-Leistungsmodule (1) erstreckt, einen Kern (70) und einen elektrischen Stromsensor (80), der oberhalb der Vielzahl der 2-in-1-Leistungsmodule (1) bereitgestellt ist, durchdringt, wobei jede Wechselstrom-Sammelschiene (60) von oberhalb der Leistungswandlervorrichtung (100) gezogen ist.

4. Leistungswandlervorrichtung nach einem der Ansprüche 1 bis 3,
wobei eine Steuerleiterplatte (140) auf derselben Seite der 2-in-1-Leistungsmodule (1) wie die Ansteuerleiterplatten (130) angeordnet ist.

5. Leistungswandlervorrichtung nach einem der Ansprüche 1 bis 4,
wobei ein Trennschalter (200) auf derselben Seite der 2-in-1-Leistungsmodule (1) wie die elektrischen Leistungsanschlüsse der positiven Gleichstrom-Sammelschiene (40) und der negativen Gleichstrom-Sammelschiene (50) und die Ausgangsanschlüsse (115) der Wechselstrom-Sammelschienen (60) angeordnet ist.

6. Leistungswandlervorrichtung nach einem der Ansprüche 1 bis 5,
wobei die Ansteuerleiterplatten (130) in der vertikalen Richtung angeordnet sind, und Trennplatten (132) zwischen den Ansteuerleiterplatten (130) bereitgestellt sind.

7. Leistungswandlervorrichtung nach einem der Ansprüche 1 bis 6,
wobei die Leistungswandlervorrichtung (100) eine Wechselrichterschaltung ist, in der die 2-in-1-Leistungsmodule (1) jeweils auf einzelne Phasen des dreiphasigen Wechselstrom-Leistung angewendet werden.

8. Leistungswandlervorrichtung nach einem der Ansprüche 1 bis 7,
wobei die Leistungswandlervorrichtung (100) ausgelegt ist, um auf einem Fahrzeug (900) angebracht zu werden, wobei die Breitenseitenrichtung der 2-in-1-Leistungsmodule (1) eine Fahrtrichtung des Fahrzeugs (900) ist.

9. Fahrzeug, an dem eine Leistungswandlervorrichtung (100) nach Anspruch 8 angebracht ist.

## Revendications

1. Dispositif de conversion de puissance, comprenant :
plusieurs modules d'alimentation 2 en 1 (1) présentant chacun une forme cuboïde rectangulaire définissant une direction latérale longue (4) qui est une direction verticale et une direction latérale courte (5) qui est une direction horizontale ;
un refroidisseur (150) configuré pour refroidir les modules d'alimentation 2 en 1 (1) ;
un condensateur (120) faisant face à un premier côté rectangulaire de chaque module d'alimentation 2 en 1 (1), et ayant une surface avant verticale faisant face au refroidisseur et aux modules d'alimentation 2 en 1, une surface arrière verticale, une surface verticale latérale gauche comprenant des bornes pour une connexion à des barres omnibus CC, et une surface verticale latérale droite parallèle à la surface verticale latérale gauche ;
une barre omnibus CC positive en forme de L (40) connectée aux modules d'alimentation 2 en 1 (1), la barre omnibus CC positive (40) ayant une borne d'alimentation électrique pour une connexion au condensateur (120) ;
une barre omnibus CC négative en forme de L (50) connectée aux modules d'alimentation 2 en 1 (1), la barre omnibus CC négative (50) ayant une borne d'alimentation électrique pour une connexion au condensateur (120) ;
des fils de signal de commande respectifs (3) connectés aux modules d'alimentation 2 en 1 (1) ; et
des cartes de circuit imprimé de commande respectives (130), situées sur un même plan, et configurées pour délivrer des signaux de commande aux fils de signal de commande (3) ;
dans lequel les modules d'alimentation 2 en 1 (1) sont montés sur le refroidisseur (150) le long d'une direction verticale qui est également une direction de côté long (4) des modules d'alimentation 2 en 1 (1) ;
le dispositif de conversion de puissance comprend en outre : une pluralité de barres omnibus CA (60) connectées respectivement aux modules d'alimentation 2 en 1 (1), chaque barre omnibus CA (60) ayant une borne de sortie (115), chaque barre omnibus CA s'étendant horizontalement parallèlement les unes par rapport aux autres sur le même plan parallèle à la surface du refroidisseur ;
la barre omnibus CC positive en forme de L et la barre omnibus CC négative en forme de L ayant respectivement des parties avant verticales parallèles au refroidisseur pour une connexion électrique aux modules d'alimentation et situées entre la surface avant verticale du condensateur et les barres omnibus CA et des parties verticales latérales perpendiculaires au refroidisseur, les parties verticales latérales s'étendant parallèlement à la surface verticale latérale gauche du condensateur, et les parties verticales latérales contenant respectivement les bornes d'alimentation électrique pour une connexion au condensateur ; et
dans lequel des connexions des fils de signal de commande (3) aux cartes de circuit imprimé respectives (130) avec les cartes de circuit imprimé (130) font face à la surface verticale côté droit du condensateur (120) ;
et dans lequel une ligne centrale (121), perpendiculaire à la direction verticale et au refroidisseur (150), du condensateur (120) est située sur un côté supérieur d'une ligne centrale (133), perpendiculaire à la direction verticale et au refroidisseur, des cartes de circuit imprimé (130) .

2. Dispositif de conversion de puissance selon la revendication 1,
dans lequel dans chaque module d'alimentation 2 en 1 (1), une borne d'électrode CC positive (6a), une borne d'électrode CC négative (6b) et une borne CA (6c) sont disposées dans cet ordre ou dans l'ordre opposé le long de la direction verticale, et une borne de connexion du fil de signal de commande respectif (3) est disposée dans un espace entre la borne d'électrode CC négative (6b) et la borne CA (6c) ;
la borne d'électrode CC positive (6a) est connectée au condensateur (120) avec une plaque conductrice formant la barre omnibus CC positive (40) ;
la borne d'électrode CC négative (6b) est connectée au condensateur (120) avec une plaque conductrice formant la barre omnibus CC négative (50) ; et
la barre omnibus CC positive (40) et la barre omnibus CC négative (50) sont adjacentes l'une à l'autre dans une forme de plaques parallèles.

3. Dispositif de conversion de puissance selon la revendication 2,
dans lequel chaque barre omnibus CA (60) s'étend depuis l'une des bornes CA (6c) dans la direction de côté court des modules d'alimentation 2 en 1 (1), pénètre dans un noyau (70) et un capteur de courant électrique (80) prévu au-dessus de la pluralité des modules d'alimentation 2 en 1 (1), chaque barre omnibus CA (60) étant tirée depuis le dessus du dispositif de conversion de puissance (100).

4. Dispositif de conversion de puissance selon l'une quelconque des revendications 1 à 3,
dans lequel une carte de circuit imprimé (140) est disposée du même côté des modules d'alimentation 2 en 1 (1) que les cartes de circuit imprimé (130).

5. Dispositif de conversion de puissance selon l'une quelconque des revendications 1 à 4,
dans lequel un disjoncteur (200) est disposé du même côté des modules d'alimentation 2 en 1 (1) que les bornes d'alimentation électrique de la barre omnibus CC positive (40) et de la barre omnibus CC négative (50), et les bornes de sortie (115) des barres omnibus CA (60).

6. Dispositif de conversion de puissance selon l'une quelconque des revendications 1 à 5,
dans lequel les cartes de circuit imprimé (130) sont agencées dans la direction verticale, et des plaques de séparation (132) sont prévues entre les cartes de circuit imprimé (130).

7. Dispositif de conversion de puissance selon l'une quelconque des revendications 1 à 6,
dans lequel le dispositif de conversion de puissance (100) est un circuit onduleur dans lequel les modules d'alimentation 2 en 1 (1) sont appliqués chacun à des phases individuelles de l'alimentation CA triphasée.

8. Dispositif de conversion de puissance selon l'une quelconque des revendications 1 à 7,
dans lequel dans le dispositif de conversion de puissance (100) configuré pour être monté sur un véhicule (900), la direction de côté court des modules d'alimentation 2 en 1 (1) est une direction de déplacement du véhicule (900).

9. Véhicule monté avec le dispositif de conversion de puissance (100) selon la revendication 8.
